# EUROPEAN PATENT APPLICATION

(11) **EP 4 040 931 A1**
(43) Date of publication of application: **10.08.2022**
(21) Application number: 20871345.3
(22) Date of filing: 30.09.2020
(51) Int. Cl.: H05K 7/20, H01M 10/613, H01M 10/615, H01M 10/625, H01M 10/6554, H01M 10/6556, H01M 10/6563, H01M 10/6568, H01M 50/20

(54) **HEATING ELEMENT ACCOMMODATION CASE AND STRUCTURE**

(30) Priority: 04.10.2019 JP 2019184144; 04.10.2019 JP 2019184145; 05.06.2020 JP 2020098944
(71) Applicant: Mitsui Chemicals, Inc., Tokyo 105-7122 (JP)
(72) Inventor: KIMURA, Kazuki, Sodegaura-shi, Chiba 299-0265 (JP); KURIYAGAWA, Mizue, Sodegaura-shi, Chiba 299-0265 (JP); TORII, Tomoki, Tokyo 105-7122 (JP); OKUMURA, Yasuyuki, Nagoya-shi, Aichi 466-0059 (JP); TOBA, Norihide, Nagoya-shi, Aichi 466-0059 (JP); NAKATA, Takashi, Nagoya-shi, Aichi 466-0059 (JP)
(74) Representative: J A Kemp LLP
(86) International application number: PCT/JP2020/037244
(87) International publication number: WO 2021/066044

(57) **Abstract**

A heating element accommodation case, comprising a casing to accommodate a heating element, the casing having a flow channel configured for a liquid to flow through, a portion of the flow channel being formed of a resin; and a heating element accommodation case, comprising a casing to accommodate a heating element and an airflow channel configured for air to flow through.

## Description

### [Technical Field]

The invention relates to a heating element accommodation case and a structure.

### [Background Art]

Objects that generate heat during operation (i.e., heating elements), such as CPUs for computers or secondary batteries for electronic vehicles, are generally accommodated in a case while in use.

As the performance and power of heating elements are improved, the importance of cooling the heating elements to avoid overheating has been increasing. For example, Patent Document 1 discloses a structure having a battery case for accommodating a battery module and a cooler, wherein the cooler is disposed between a basal surface of the battery module and a basal plate of the battery case, and the battery module is cooled by a coolant flowing inside the cooler.

### [Prior Art Document]

### [Patent Document]

[Patent Document 1] Japanese Patent Application Laid-Open No. 2018-163741

### [Summary of the Invention]

### [Problem to be Solved by the Invention]

The structure disclosed in Patent Document 1 is produced by assembling a battery case and a cooler, which are respectively obtained by separate processes. Therefore, improvement in production efficiency is required for a production method of the structure described in Patent Document 1, which includes complicated processes for production and assembly of respective members. In addition, reducing the number of the members is effective for reducing the weight of the structure.

In view of the foregoing, an embodiment of the present disclosure aims to provide a heating element accommodation case, which can adjust the temperature of a heating element with a simple configuration, and a structure including the heating element accommodation case and a heating element.

Although the main objective of the structure described in Patent Document 1 is to cool a base portion of the heating element and a portion around the same, there is also a need to cool portions other than a base portion (such as side and upper portions) depending on the type of the heating element. For example, lithium ion batteries for vehicles often have terminals (such as bus bars and tab leads) at a side or top portion thereof, and a portion with terminals generates more heat than other portions. However, it is difficult to simply cool the side or top portions of the battery, because the terminals may cause a fire by short circuiting upon contact with water as a coolant.

In view of the foregoing, an embodiment of the present disclosure aims to provide a heating element accommodation case, which can adjust the temperature of a specific portion of a heating element in a safe and efficient manner, and a structure including the heating element accommodation case and a heating element.

### [Means for Solving the Problem]

The means for solving the problem includes the following embodiments.
<1> A heating element accommodation case, comprising a casing to accommodate a heating element, the casing having a flow channel configured for a liquid to flow through, a portion of the flow channel being formed of a resin.
<2> The heating element accommodation case according to <1>, wherein the casing has a metal portion that includes a metal.
<3> The heating element accommodation case according to <2>, wherein the metal portion has, at at least a part of a surface of the metal portion, a concave-convex structure that is formed by a roughening process.
<4> The heating element accommodation case according to <2> or <3>, wherein the casing further has a resin portion that includes a resin, and the metal portion has a concave-convex structure at a portion to be joined to the resin portion.
<5> The heating element accommodation case according to any one of <2> to <4>, wherein at least a part of the metal portion is disposed at a position configured to contact the heating element.
<6> The heating element accommodation case according to any one of <1> to <5>, wherein at least a part of a portion surrounding a space through which a liquid flows in the flow channel is formed of a resin.
<7> The heating element accommodation case according to <6>, wherein at least a part of a portion surrounding a space through which a liquid flows in the flow channel is formed of a metal.
<8> The heating element accommodation case according to any one of <1> to <7>, wherein the flow channel is disposed at at least one of a base portion, an upper portion or a side portion of the heating element.
<9> The heating element accommodation case according to <8>, wherein the flow channel is disposed at at least an upper portion of the heating element.
<10> The heating element accommodation case according to <8>, wherein the flow channel comprises a first flow channel disposed at a base portion of the heating element and a second flow channel disposed at an upper portion of the heating element, and one of the first flow channel or the second flow channel adjusts a temperature of a terminal of the heating element and the other of the first flow channel or the second flow channel adjusts a temperature of a main body of the heating element.
<11> The heating element accommodation case according to <8>, wherein the flow channel comprises a first flow channel disposed at a base portion of the heating element and a second flow channel disposed at an upper portion of the heating element, and one of the first flow channel or the second flow channel cools the heating element and the other of the first flow channel or the second flow channel warms the heating element.
<12> The heating element accommodation case according to any one of <1> to <11>, wherein at least one flow channel is disposed near a high-heating portion of the heating element.
<13> A heating element accommodation case, comprising a casing to accommodate a heating element and an airflow channel configured for air to flow through.
<14> The heating element accommodation case according to <13>, wherein the airflow channel is isolated from a space in which the heating element is accommodated.
<15> The heating element accommodation case according to <13> or <14>, which is installed in a mobile object.
<16> The heating element accommodation case according to <13> or <14>, wherein the airflow channel is configured for air to flow along a direction in which the mobile object moves.
<17> The heating element accommodation case according to <13> or <14>, wherein air is caused to flow through the airflow channel by a blower.
<18> The heating element accommodation case according to any one of <13> to <17>, wherein at least a part of the airflow channel is formed of a metal.
<19> The heating element accommodation case according to <18>, wherein at least a portion of the airflow channel that contacts the casing is formed of a metal.
<20> The heating element accommodation case according to any one of <13> to <19>, wherein the casing has a flow channel configured for a liquid to flow through.
<21> The heating element accommodation case according to <20>, wherein the flow channel is disposed at a position at which the airflow channel is not disposed.
<22> The heating element accommodation case according to <20> or <21>, wherein at least a part of a portion surrounding a space through which a liquid flows in the flow channel is formed of a resin.
<23> The heating element accommodation case according to <22>, wherein at least a part of a portion surrounding a space through which a liquid flows in the flow channel is formed of a metal.
<24> The heating element accommodation case according to any one of <20> to <23>, wherein the flow channel is disposed at at least one of a base portion, an upper portion or a side portion of the heating element.
<25> The heating element accommodation case according to <24>, wherein the flow channel is disposed at at least an upper portion of the heating element.
<26> The heating element accommodation case according to any one of <1> to <25>, wherein the casing has a vent that communicates an inside of the casing with an outside of the casing.
<27> A structure, comprising the heating element accommodation case according to any one of <1> to <26>, and a heating element that is accommodated in the heating element accommodation case.
<28> The structure according to <27>, wherein the heating element is at least one selected from the group consisting of a secondary battery module, an electronic component device, and a power conversion device.

### [Effect of the Invention]

According to the invention, a heating element accommodation case, which can adjust the temperature of a heating element with a simple configuration, and a structure including the heating element accommodation case and a heating element are provided.

### [Brief Explanation of the Drawings]

Fig. 1 is a schematic sectional view illustrating an exemplary configuration of a heating element accommodation case having a flow channel.
Fig. 2 is a schematic sectional view illustrating an exemplary configuration of a flow channel.
Fig. 3 is a schematic sectional view illustrating an exemplary configuration of a flow channel.
Fig. 4 is a schematic sectional view illustrating an exemplary configuration of a heating element accommodation case having an airflow channel.
Fig. 5 is a schematic sectional view illustrating an external appearance of an exemplary configuration of a heating element accommodation case.
Fig. 6 is a perspective view of the heating element accommodation case illustrated in Fig. 5, from which a lid of the casing is removed.
Fig. 7 is a perspective view of the heating element accommodation case illustrated in Fig. 5, being disposed in an inverted manner.
Fog. 8 is a schematic sectional view illustrating a device for evaluation prepared in the Examples.

### [Embodiments for Implementing the Invention]

In the present disclosure, a numerical range indicated using "to" includes the numerical values before and after "to" as a minimum value and a maximum value, respectively.

In numerical ranges stated in a stepwise manner in the present disclosure, the upper limit value or the lower limit value stated in one numerical range may be replaced with the upper limit value or the lower limit value of another numerical range stated in a stepwise manner. Further, in the numerical range stated in the present disclosure, the upper limit value or the lower limit value of the numerical range may be replaced with the values shown in the examples.

In the present disclosure, when a component in a material contains a plurality of substances corresponding to the component, the content of the component refers to the total content of the plurality of substances present in the material, unless otherwise specified.

### < Heating element accommodation case (First embodiment)>

The heating element accommodation case in the first embodiment is a heating element accommodation case, comprising a casing to accommodate a heating element, the casing having a flow channel configured for a liquid to flow through, a portion of the flow channel being formed of a resin.

In the heating element accommodation case, the casing itself has a flow channel and has a function to adjust the temperature of a heating element. Therefore, it is possible to adjust the temperature of a heating element in an efficient manner with a simple configuration, as compared with a case in which a casing and a device for adjusting the temperature are independent components from each other. It is also possible to expect an effect of downsizing the production cost by reducing the number of the components or the time for assembling the same.

Further, in the heating element accommodation case in the present invention, at least a part of the flow channel is formed of a resin. Therefore, for example, it is easier to form a flow channel having a complicated shape or to downsize the production cost thereof, as compared with a case in which a flow channel is formed from a metal plate. It is also possible to reduce the weight of the heating element accommodation case.

In the present disclosure, the "function to adjust the temperature" of a heating element includes a function to cooling the heating element (i.e., decreasing the temperature or suppressing an increase of the temperature) and a function to warm the heating element (i.e., increasing the temperature or suppressing a decrease of the temperature). Exemplary cases of warming a heating element include a case of running an automobile mounting a battery as a heating element in a cold area.

The type of a liquid to flow through a flow channel is not particularly limited, and may be selected from those commonly used for coolers.

The location and the number of the flow channel in the heating element accommodation case are not particularly limited. For example, the flow channel may be disposed at at least one of a side of a direction of gravitational force of a heating element (hereinafter, also referred to as a base portion of a heating element); a side of an inverse direction of gravitational force of a heating element (hereinafter, also referred to as an upper portion of a heating element); or a side of a direction perpendicular to a direction of gravitational force of a heating element (hereinafter, also referred to as a side portion of a heating element), in a state in which the heating element is accommodated in the casing.

From the viewpoint of achieving a sufficient temperature adjustment efficiency, the flow channel is preferably disposed at a position near a surface of a heating element, more preferably at a position near a high-heating portion of a heating element (i.e., a portion that generates a relatively large amount of heat such as a terminal). The high-heating portion of the heating element may be disposed at any of a base portion of the heating element, an upper portion of the heating element, or a side portion of the heating element.

In particular, when the purpose of the flow channel is to cool a heating element, it is thought to be advantageous to dispose the flow channel at an upper portion or a side portion, especially at an upper portion, of a heating element, in view of the fact that air moves up when it is heated inside the casing; and that, when a heating element is a secondary battery module, the amount of heat generated by electrodes (such as bus bars and tab leads), which are disposed at an upper portion or a side portion of the module, is essentially greater than the amount of heat generated at a base portion of the module.

In the heating element accommodation case in the present invention, the casing itself has a flow channel. Therefore, it is easier to dispose a temperature adjustor at an upper portion of the casing, as compared with a case in which the casing and the temperature adjustor are independent components from each other.

The casing may be formed from plural components. For example, the casing may be formed from a main body for accommodating a heating element, a lid, and other components as necessary. When the casing is formed from plural components, a flow channel may be disposed at at least one of the components.

The material for the casing of the heating element accommodation case is not particularly limited, as long as at least part of a flow channel is formed of a resin. For example, the casing may be formed of a metal, a resin, ceramics, carbon, glass or the like. The casing may be formed of a single kind of material, or may be formed from two or more kinds thereof.

From the viewpoint of temperature adjustment efficiency, the casing preferably has a portion including a metal (metal portion), more preferably has at least part of a metal portion at a position configured to contact a heating element.

The type of the metal is not particularly limited, and may be selected depending on the purpose of the heating element accommodation case, and the like. For example, the metal may be at least one selected from the group consisting of iron, copper, nickel, gold, silver, platinum, cobalt, zinc, lead, tin, titanium, chrome, aluminum, magnesium, manganese and an alloy including the aforementioned metal (such as stainless steel, brass and phosphor bronze).

From the viewpoint of thermal conductivity, aluminum, aluminum alloy, copper and copper alloy are preferred as the metal, and copper and copper alloy are more preferred as the metal.

From the viewpoint of reducing the weight and securing the strength, aluminum and aluminum alloy are more preferred as the metal.

The type of the resin is not particularly limited, and may be selected depending on the purpose of the heating element accommodation case, and the like. For example, the resin may be a thermoplastic resin (including an elastomer) such as polyolefin resin, polyvinyl chloride, polyvinylidene chloride, polystyrene resin, AS resin (acrylonitrile/styrene resin), ABS resin (acrylonitrile/butadiene/styrene resin), polyester resin, poly(meth)acrylic resin, polyvinyl alcohol, polycarbonate resin, polyamide resin, polyimide resin, polyether resin, polyacetal resin, fluorine resin, polysulfone resin, polyphenylene sulfide resin and polyketone resin; and a thermosetting resin such as phenol resin, melamine resin, urea resin, polyurethane resin epoxy and unsaturated polyester resin. The resin may be used alone or in combination of two or more kinds.

The resin may include an additive of various kinds. Examples of the additive include a filler, a thermal stabilizer, an antioxidant, a pigment, a weathering stabilizer, a flame retardant, a plasticizer, a dispersant, a lubricant, a releasing agent, and an antistatic agent.

From the viewpoint of adjusting a difference in linear coefficient of expansion between a resin and a metal, or from the viewpoint of improving the mechanical strength of a resin, the resin may include a filler. Examples of the filler include glass fiber, carbon fiber, carbon particles, clay, talc, silica, minerals and cellulose fiber. Among these, glass fiber, carbon fiber, talc and minerals are preferred. The filler may be used alone or in combination of two or more kinds.

From the viewpoint of thermal efficiency, a resin portion that forms the flow channel preferably has a high degree of thermal insulation, in order to prevent the conduction of heat from cooling water to the exterior. For example, the resin portion may include air bubbles formed in a process of foam molding.

In the following, exemplary configurations of the heating element accommodation case are explained by referring to the drawings.

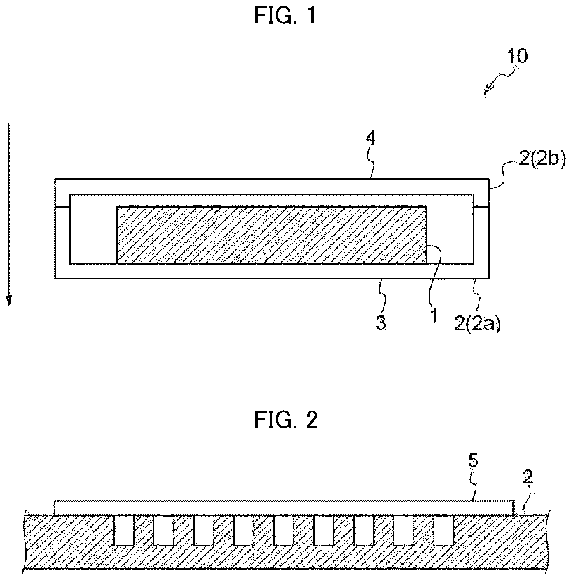

The heating element accommodation case 10 shown in Fig. 1 has a casing 2 in which a heating element 1 is accommodated. The casing 2 consists of a main body 2a and a lid 2b. The casing 2 (main body 2a) has a flow channel (not shown) at a portion 3 facing a base portion of the heating element 1 (hereinafter, also referred to as a base portion 3 of the casing 2). The arrowhead indicates a direction of gravitational force.

From the viewpoint of temperature adjustment efficiency, a space preferably does not exist between the heating element 1 and a portion of the casing 2 at which the flow channel is disposed; or if there is a space between the heating element 1 and a portion of the casing 2 at which the flow channel is disposed, the space is preferably filled with a highly heat-conductive substance (for example, thermal interface materials (TIM) or heat-conductive adhesives).

The heating element accommodation case 10 may have a flow channel at a position other than the base portion 3 of the casing 2, instead of the base portion 3 of the casing 2. Alternatively, the heating element accommodation case 10 may have a flow channel at a position other than the base portion 3 of the casing 2, in addition to the base portion 3 of the casing 2. For example, the heating element accommodation case 10 may have a flow channel at an upper portion 4 of the casing 2 or at a side portion of the casing 2; or may have a flow channel at least two of an upper portion 4, a base portion 3 or a side portion of the casing 2.

In conventional heating element accommodation cases, generally having a cooler at a base portion of a heating element, the amount of heat generated by the heating element may be especially large at an upper portion or a side portion thereof, depending on the type of the heating element (such as secondary battery modules). In that case, an effect of adjusting the temperature can be achieved more efficiently by disposing a flow channel at a position facing an upper portion or a side portion of the heating element.

Exemplary configurations of the casing having a flow channel at plural positions include a configuration in which the casing has a first flow channel at a base portion of the heating element and a second flow channel at an upper portion of the heating element, such as the following cases (1) and (2).
(1) a configuration in which a first flow channel disposed at a base portion of the heating element and a second flow channel disposed at an upper portion of the heating element adjust the temperature of different positions of the heating element. For example, one of the first flow channel or the second flow channel focuses on the adjustment of a temperature at a region at which the heating element exhibits a relatively high temperature, and the other one of the first flow channel or the second flow channel focuses on the adjustment of a temperature at a region other than the region at which the heating element exhibits a relatively high temperature. When the heating element is a secondary battery module, the region at which the heating element exhibits a relatively high temperature corresponds to a region with a terminal or adjacent areas thereof.
(2) a configuration in which a first flow channel disposed at a base portion of the heating element and a second flow channel disposed at an upper portion of the heating element adjust the temperature of the heating element in different ways. For example, a configuration in which one of the first flow channel or the second flow channel cools the heating element and the other one of the first flow channel or the second flow channel warms the heating element.

Specific embodiments of the flow channel are not particularly limited, as long as a portion of the flow channel is formed of a resin.

In the present disclosure, a wording "a portion of the flow channel is formed of a resin" refers to that a portion surrounding a space through which a liquid flows in the flow channel is formed of a resin. Namely, the wording refers to that a portion surrounding a space through which a liquid flows in the flow channel is formed of a resin, and another portion surrounding a space through which a liquid flows in the flow channel is formed of a material other than a resin (preferably a metal).

Specific examples of a case in which a portion surrounding a space through which a liquid flows in the flow channel is formed of a resin include a state in which a flow channel is a closed space created from a groove formed at an internal surface (a surface facing a heating element) of the casing and a component disposed over the groove (hereinafter, referred to as a first embodiment); and a state in which a flow channel is a closed space created from an outer surface of the casing (a surface not facing a heating element) and a component having a groove that is disposed on the outer surface of the casing (hereinafter, referred to as a second embodiment).

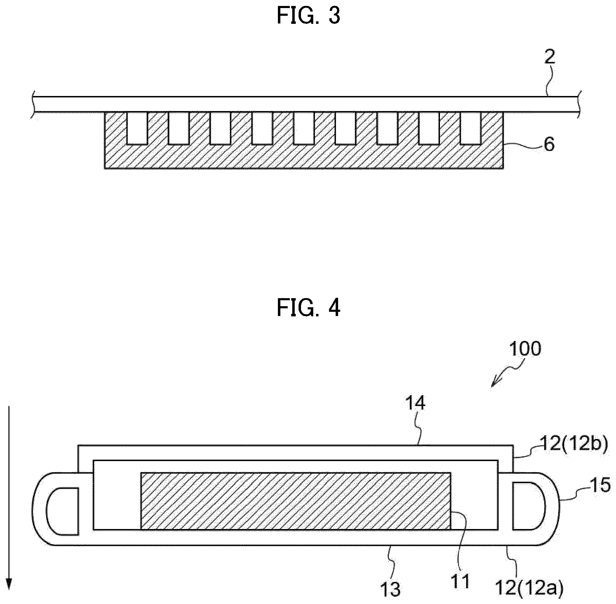

In the following, configurations of the first embodiment and the second embodiments are explained by referring to Figs. 2 and 3. The location of a portion shown in Figs. 2 and 3 in the casing is not particularly limited, and may be any of a base portion, an upper portion or a side portion of the casing.

Fig. 2 is an enlarged view of a portion with a flow channel of a casing of the first embodiment.

In Fig. 2, the casing 2 has a groove of a shape of the flow channel at an inner surface thereof, and a component 5 is disposed on the groove to create a closed space as the flow channel.

From the viewpoint of processability for the groove, at least a portion of the casing 2 having a groove is preferably formed of a resin. From the viewpoint of temperature adjustment efficiency, at least a portion of the component 5 that contacts a groove of the casing 2 is preferably formed of a metal.

Fig. 3 is an enlarged view of a portion with a flow channel of a casing of the second embodiment.

In Fig. 3, a component 6, having a groove of a shape of a flow channel, is disposed at an outer surface of the casing 2 to create a closed space as the flow channel.

From the viewpoint of processability for the groove, the component 6 having a groove is preferably formed of a resin. From the viewpoint of temperature adjustment efficiency, at least a portion of the casing 2 that contacts the component 6 is preferably formed of a metal.

When the casing has a flow channel at plural positions, the positions may have a flow channel of the same embodiment or different embodiments.

The casing (including a flow channel) may have a portion at which a portion including a metal (metal portion) and a portion including a resin (resin portion) are in contact with each other. The metal portion and the resin portion may be fixed to each other with a means such as adhesives, screws or fix tapes; or may be fixed to each other without a means such as adhesives, screws or fix tapes. In the following, fixing without a means as adhesives, screws or fix tapes may be referred to as joining.

In view of the strength and the handleability, UD (unidirectional) tapes, in which fibers of carbon, glass or the like are disposed in a unidirectional manner in a resin, are preferred as the fix tapes.

Not only for the purpose of fixing a metal portion to a resin portion, for example, an effect of improving the surface stiffness of the metal portion may be achieved by attaching a UD tape thereto. As a result, a casing with a reduced weight and a reduced thickness may be produced.

When a portion at which a metal portion and a resin portion are in contact with each other is a flow channel (a portion surrounding a space through which a liquid flows), the metal portion and the resin portion are preferably joined together from the viewpoint of preventing a leakage of a liquid. In that case, it is possible to further reinforce the joined portion with a means for fixing as mentioned above.

Specific methods for joining a metal portion to a resin portion include a method of roughening a surface of a metal portion. When a surface of a metal portion is roughened, a surface of the resin portion enters a concave-convex structure of the roughened surface formed at a surface of the metal portion, and the metal portion and the resin portion are joined tightly by an anchor effect.

In a case of cooling a heating element, the concave-convex structure formed at a surface of the metal portion has a function to improve the heat-dissipation efficiency by increasing a surface area, in addition to a function to improve the joining strength with respect to a resin portion. Therefore, a concave-convex structure may be formed at a portion not to be joined to a resin portion.

The state of a concave-convex structure formed at a surface of a metal portion is not particularly limited, as long as a sufficient degree of joining strength with respect to a resin portion is achieved.

The average pore size of the concave portion in the concave-convex structure may be, for example, from 5 nm to 250 µm, preferably from 10 nm to 150 µm, more preferably from 15 nm to 100 µm.

The average depth of the concave portion in the concave-convex structure may be, for example, from 5 nm to 250 µm, preferably from 10 nm to 150 µm, more preferably from 15 nm to 100 µm.

When at least one of the average pore size or the average depth of the concave portion in the concave-convex structure is within the above ranges, the joining of the metal portion with the resin portion tends to be stronger.

The average pore size and the average depth of the concave portion in the concave-convex structure can be measured with an electronic microscope or a laser microscope. Specifically, the average pore size and the average depth of the concave portion are calculated as an arithmetic average value of the measured values of 50 concave portions, which are arbitrarily selected from an image of a surface of the metal portion and an image of a section of a surface of the metal portion.

The method for the roughening of a surface of the casing is not particularly limited, and may be performed by various known methods.

Examples of the method include a method using laser light as described in Japanese Patent No. 4020957; a method of immersing a surface of the casing in an aqueous solution of an inorganic base such as NaOH or an inorganic acid such as HCl or HNO₃; a method of subjecting a surface of the casing to anodization as described in Japanese Patent No. 4541153; a substitution crystallization method in which a surface of the casing is etched with an aqueous solution including an acid-based etchant (preferably an inorganic acid, ferric ion or cupric ion) and optionally including manganese ions, aluminum chloride hexahydrate, sodium chloride or the like, as described in International Publication No. 2015/8847; a method of immersing a surface of the casing in an aqueous solution of at least one selected from hydrazine hydrate, ammonia or a watersoluble amine compound (hereinafter, also referred to as an NMT method), as described in International Publication No. 2009/31632; a method of treating a surface of the casing with a warm water, as described in JP-A No. 2008-162115; a blast treatment; and a laser treatment.

It is possible to select a method for roughening depending on the material of metal portion, desired configurations of the concave-convex structure, and the like.

The surface of the metal portion may be subjected to a treatment to add a functional group, in addition to a roughening treatment. The addition of a functional group to a surface of the metal portion increases the amount of chemical binding sites between a surface of the metal portion and a surface of the resin portion, and the binding strength thereof tends to further improve.

The treatment to add a functional group to a surface of the metal portion is preferably performed either at the same time as the roughening treatment or after the roughening treatment.

The method for the addition of a functional group to a surface of the metal portion is not particularly limited, and may be performed by various known methods.

Examples of the method include a method of immersing a surface of the metal portion to a solution prepared by dissolving a chemical substance having a functional group to water or an organic solvent such as methyl alcohol, isopropyl alcohol, ethyl alcohol, acetone, toluene, ethyl cellosolve, dimethyl formaldehyde, tetrahydrofuran, methyl ethyl ketone, benzene, ethyl acetate ether or the like; a method of coating or spraying a surface of the metal portion with a chemical substance having a functional group or a solution including the same; and a method of attaching a film including a chemical substance having a functional group to a surface of the metal portion.

When the addition of a functional group is performed at the same time as the roughening treatment, examples of the method for the addition include wet etching, chemical conversion treatment, and anode oxidation, performed with a solution including a chemical substance having a functional group.

A state in which a metal portion and a resin portion are joined together may be formed by, for example, applying a resin in a melted state to a surface of a metal portion. When a resin applied to a surface of a metal portion is in a melted state, a degree of contact of a resin with respect to a surface of a metal portion is improved (for example, an anchor effect is caused by a resin entering a concave-convex structure at a surface of a metal portion), whereby a resin portion and a metal portion are joined more tightly.

The resin in a melted state may be formed into a desired shape using a mold or the like. The method for forming the resin is not particularly limited, and may be a known method such as injection molding.

A metal portion may be joined to a resin portion while inserting a third material between the metal portion and the resin portion. Examples of the third material include adhesives and fix tapes. It is also possible to join the metal portion to the resin portion more tightly by allowing an adhesive or an adhesive of a fix tape to enter a concave-convex structure at a surface of the metal portion. It is also possible to use a mechanical fastening means such as screws or packing for the purpose of reducing the risk of leakage.

The casing of the heating element accommodation case may have a vent that communicates an inside of the casing with an outside of the casing. When the casing has a vent, effects of suppressing excessive moisture or condensation inside the casing may be expected. The effect achieved by a vent is especially significant when the casing is formed of a metal.

Further, when the casing has a vent, effects of preventing the casing from breakage caused by an increase of inner pressure may be expected.

When the casing has a vent, the position and the number thereof are not particularly limited, and may be selected depending on the configuration of the casing and the like.

The configuration of the vent is not particularly limited. For example, an opening portion of the vent may be covered with a material that is permeable to air, moisture or the like.

In addition to the aforementioned configuration, the heating element accommodation case may have an airflow channel configured for air to flow through. In a case of cooling a heating element, an airflow channel provides an effect of adjusting the temperature (cooling) by air to flow through the airflow channel, in addition to an effect of adjusting the temperature (cooling) by a liquid to flow through a flow channel.

As for the details and preferred embodiments of the airflow channel, the details and preferred embodiments of the airflow channel of a heating element accommodation case in the second embodiment, as described later, may be referred to.

As necessary, the heating element accommodation case may have other components for the purposes of insulating a heating element from a base portion of the casing, shielding of electromagnetic waves, prevention of leakage at the flow channel, and the like.

The heating element to be accommodated in the heating element accommodation case is not particularly limited. For example, the heating element may be an electric source such as secondary battery modules and solid-state batteries, an electronic device such as CPUs, power conversion devices such as inverters and convers, or a power source such as motors.

The purpose of the heating element accommodation case are not particularly limited, and may be any purpose for which a heating element to be accommodated therein is used.

In the following, specific examples of the configuration of the heating element accommodation case are explained by referring to the drawings.

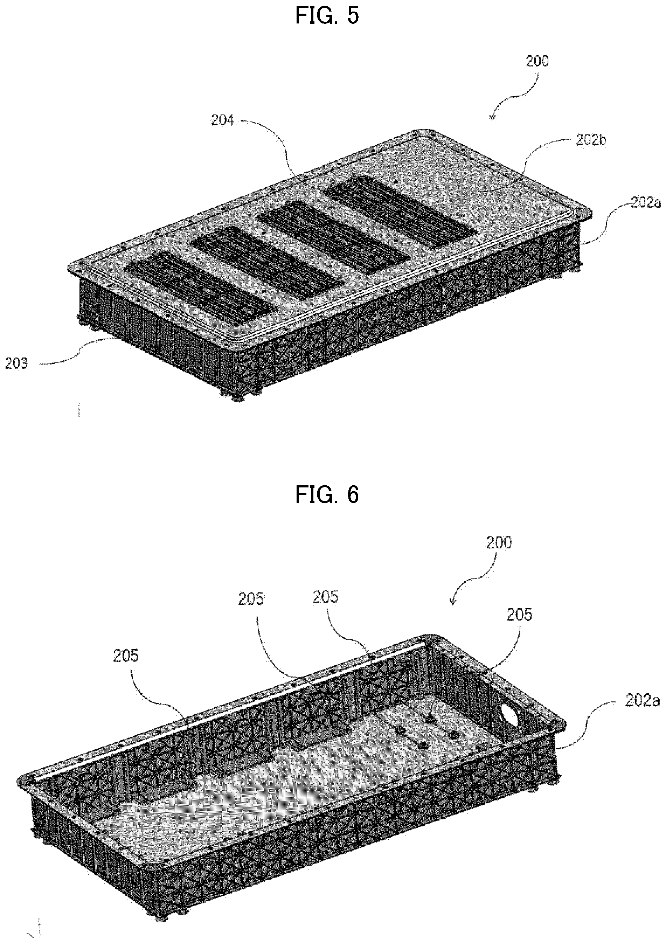

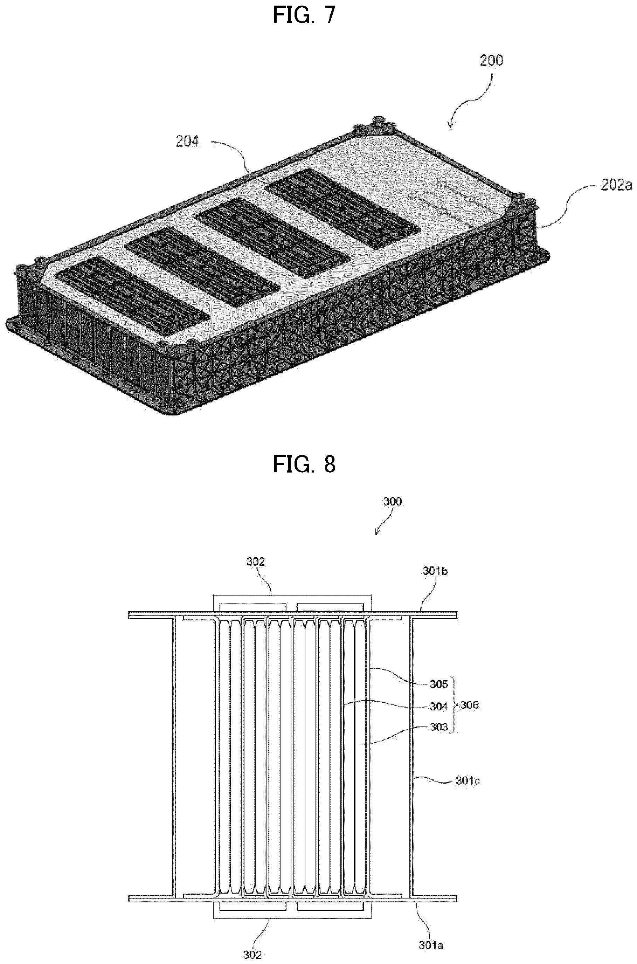

Fig. 5 is a perspective view of an external appearance of a heating element accommodation case; Fig. 6 is a perspective view of the heating element accommodation case shown in Fig. 5 from which a lid of the casing is removed; and Fig. 7 is a perspective view of the heating element accommodation case shown in Fig. 5 being disposed in an inverted manner.

In Fig. 5, the heating element accommodation case 200 has a main body 202a, which is made of a metal and has a roughened surface, and a lid 202b. To side portions of the main body 202a, reinforcing ribs 203 are joined. To the lid 202b, flow channel panels 204 made of a resin are joined.

As shown in Fig. 6, brackets 205 made of a resin are joined to an inner side of the main body 202a. As shown in Fig. 7, flow channel panels 204 made of a resin are joined to a base portion of the main body 202a.

The flow channel panel 204 made of a resin has a groove of a shape of a flow channel at a surface to be attached to the casing. By attaching the flow channel panel 204 to a surface of the casing, a flow channel is created as a closed space formed of the groove.

### <Heating element accommodation case (Second embodiment)>

The heating element accommodation case in the second embodiment is a heating element accommodation case, comprising a casing to accommodate a heating element and an airflow channel configured for air to flow through.

The heating element accommodation case has an airflow channel configured for air to flow through. Therefore, the temperature at desired portions of a heating element is adjusted with air flowing through the airflow channel. Use of air instead of a liquid for temperature adjustment is advantageous in terms of avoiding problems such as leakage of a liquid, simplifying the configuration of the heating element accommodation case, and reducing the weight of the heating element accommodation case.

The airflow channel is preferably isolated from a space in which the heating element is accommodated. When the airflow channel is isolated from a space in which the heating element is accommodated, it is possible to avoid the heating element from contacting moisture or dust included in air flowing through the airflow channel.

The specific configuration of the airflow channel is not particularly limited. For example, the airflow channel may be integrated with the casing, or the airflow channel may be a separate component to attach to the casing.

The material for the airflow channel is not particularly limited. For example, the material may be selected from those that may be used for the casing.

From the viewpoint of temperature adjustment efficiency, the airflow channel preferably has at least a portion thereof, more preferably at least a portion to be in contact with a portion at the side of the casing, being formed of a metal.

The method for causing air to flow through the airflow channel is not particularly limited. For example, air may be caused to flow by a blower such as a fan, or by natural ventilation.

It is also possible to cause airflow by moving an object in which the heating element accommodation case is installed, such as running an automobile. For example, by disposing the airflow channel along a direction in which an object in which the heating element accommodation case is installed moves, it is possible to dissipate heat inside the casing at a portion thereof being in contact with the airflow channel.

In conventional heating element accommodation cases, generally having a cooler at a base portion of a heating element, the amount of heat generated by the heating element may be especially large at an upper portion or a side portion thereof, depending on the type of the heating element (such as secondary battery modules). In that case, an effect of adjusting the temperature can be achieved more efficiently by disposing an airflow channel at a position facing an upper portion or a side portion of the heating element.

The position and the number of the airflow channel is not particularly limited. From the viewpoint of achieving a sufficient temperature adjustment efficiency, the airflow channel is preferably disposed at a position near a surface of a heating element, more preferably at a position near a high-heating portion of a heating element (i.e., a portion that generates a relatively large amount of heat such as a terminal). The airflow channel may be disposed at least one of a base portion of the heating element, an upper portion of the heating element, or a side portion of the heating element.

In particular, when the purpose of the airflow channel is to cool a heating element, it is thought to be advantageous to dispose the airflow channel at an upper portion or a side portion of a heating element, in view of the fact that air moves up when it is heated inside the casing; and that a heating element generally has a high-heating portion, such as a terminal, at an upper portion or a side portion thereof, as previously mentioned.

The heating element accommodation case may have a known means for temperature adjustment other than an airflow channel. For example, the heating element accommodation case may have a known means for temperature adjustment at the inside or the outside of the casing. In that case, an airflow channel may be disposed at an appropriate position other than a position for disposing a means for temperature adjustment.

The casing in itself may have a function as a means for temperature adjustment. In that case, it is possible to adjust the temperature of a heating element with a simple configuration, as compared with a case in which a means for temperature adjustment is disposed inside the casing. Further, integration of the casing with a means for temperature adjustment makes it possible to achieve an effect of reducing the production cost by reducing the number of components or reducing the time for assembly.

Examples of a means for temperature adjustment includes a flow channel for a liquid, and a heat sink.

In the following, exemplary configurations of the heating element accommodation case are explained by referring to the drawings.

In Fig. 4, the heating element accommodation case 100 has a casing 12 to accommodate a heating element 11, and the casing 12 consists of a main body 12a and a lid 12b. Outside the casing 12 (main body 12a), i.e., opposite side of the heating element 11, an airflow channel 15 for air to flow through is disposed at a position facing a side portion of the heating element (hereinafter, also referred to as a side portion of the casing 12). The arrowhead in the drawing indicates a direction of gravitational force.

The heating element accommodation case 100 shown in Fig. 4 may have an airflow channel at a position other than a side portion of the casing 12, instead of a side portion of the casing 12. The heating element accommodation case 100 shown in Fig. 4 may have an airflow channel at a position other than a side portion of the casing 12, in addition to a side portion of the casing 12. For example, the heating element accommodation case 100 may have an airflow channel at a position facing an upper portion of the heating element 11 (hereinafter, also referred to as an upper portion 14 of the casing 12), or at a position facing a base portion of the heating element 11 (hereinafter, also referred to as a base portion 13 of the heating element 12).

The casing 12 of the heating element accommodation case 100 shown in Fig. 4 may have a flow channel for a liquid to flow through (not shown). The position for the flow channel is not particularly limited, and may be at least one of an upper portion, a side portion or a base portion of the casing 12.

When the casing 12 has a flow channel, the flow channel is preferably disposed at a position at which an airflow channel is not disposed.

A space may exist or may not exist between a heating element and an airflow channel (or a flow channel).

From the viewpoint of temperature adjustment efficiency, a heating element and an airflow channel (or a flow channel) are preferably in close contact without a space therebetween. When there is a space between a heating element and an airflow channel (or a flow channel), the space is preferably filled with a highly heat-conductive material (such as TIMs or heat-conductive adhesives).

As for the details and preferred embodiments of the components other than the airflow channel, the details and preferred embodiments of the components of a heating element accommodation case in the first embodiment may be referred to.

### <Structure>

The structure in the present disclosure includes the heating element accommodation case as described above and a heating element that is accommodated in the heating element accommodation case.

The details and preferred embodiments of the heating element accommodation case and the heating element included in the structure are the same as the details and preferred embodiments of the heating element accommodation case and the heating element as described above.

### [Examples]

In the following, the present disclosure will be explained by referring to the Examples. However, the present disclosure is not limited to the Examples.

### <Example 1>

A state of temperature change of a battery module during rapid charging was examined using an evaluation device having a configuration shown in Fig. 8.

The evaluation device 300 shown in Fig. 8 has a casing that is formed of an aluminum member 301a, corresponding to a base portion of the casing; an aluminum member 301b, corresponding to a lid of the casing; and aluminum member 301c, corresponding to a side portion of the casing.

At the outside of the base portion and the lid of the casing, resin panels 302 with a groove having a shape of a flow channel are disposed, respectively.

At the inside of the base portion and the lid of the casing, TIM sheets (not shown) are disposed, respectively.

Inside the casing, there is a battery module 306 consisting of twelve lithium ion battery cells 303; five aluminum plates 304 separating the lithium ion battery cells into six pairs; and a module case 305 accommodating these components.

Inside the battery module 306, thirty-six temperature sensors (not shown) are disposed.

The evaluation device was placed in an atmosphere at 25°C. After confirming that the temperature of the battery module was 25°C, lithium ion battery cells were subjected to rapid charging for 28 minutes while allowing cooling water (20°C) to flow at a rate of 0.7 L/min, only through a flow channel formed by a resin panel at the base portion of the casing. During the charging, the temperature of the entire battery module was monitored with the temperature sensors.

The time at which the highest temperature was recorded by any one of the temperature sensors was determined as the maximum heating time (the temperature at the maximum heating time was determined as the maximum heating temperature).

The maximum heating temperature, an average temperature of the temperature sensors, and a standard deviation (σ) of the temperature of the temperature sensors, at the maximum heating time, are shown in Table 1.

### <Example 2>

The evaluation was performed in the same manner to Example 1, except that the cooling water was allowed to flow at a rate of 0.7 L/min, only through a flow channel formed by a resin panel at the lid of the casing.

### <Example 3>

The evaluation was performed in the same manner to Example 1, except that the cooling water was allowed to flow at a rate of 0.35 L/min, through a flow channel formed by a resin panel at the base portion of the casing and a flow channel formed by a resin panel at the lid of the casing, respectively.

### <Comparative Example 1>

The evaluation was performed in the same manner to Example 1, except that the cooling water was not allowed to flow through a flow channel formed by a resin panel at the base portion of the casing or a flow channel formed by a resin panel at the lid of the casing.

**[Table 1]**

| | Example 1 | Example 2 | Example 3 | Comparative Example 1 |
|---|---|---|---|---|
| Maximum heating temperature | 51.7°C | 51.1°C | 48.9°C | 56.6°C |
| Average temperature | 46.5°C | 45.8°C | 42.7°C | 54.4°C |
| σ | 3.2°C | 2.9°C | 2.8°C | 1.1°C |

As shown in Table 1, the maximum heating temperature and the average temperature of Examples 1-3, in which cooling water was allowed to flow through a flow channel formed at the outside of the casing, are lower than the maximum heating temperature and the average temperature of Comparative Example 1, in which cooling water was not allowed to flow through a flow channel, indicating superior cooling performance.

The maximum heating temperature and the average temperature of Example 2, in which cooling water was allowed to flow only through a flow channel formed at the lid of the casing (i.e., upper portion of the heating element), are lower than the maximum heating temperature and the average temperature of Example 1, in which cooling water was allowed to flow only through a flow channel formed at the base portion of the casing (i.e., the base portion of the heating element), indicating superior cooling performance. Further, the standard deviation of Example 2 is smaller than that of Example 1, indicating suppressed unevenness in the temperature inside the casing.

The maximum heating temperature and the average temperature of Example 3, in which cooling water was allowed to flow through a flow channel formed at the lid of the casing and a flow channel formed at the base portion of the casing, are lower than the maximum heating temperature and the average temperature of Examples 1 and 2, in which cooling water was allowed to flow through either one of a flow channel formed at the base portion of the casing or a flow channel formed at the lid of the casing, indicating superior cooling performance. Further, the standard deviation of Example 3 was smaller than that of Examples 1 and 2, indicating suppressed unevenness in the temperature inside the casing.

The disclosures of Japanese Patent Application Nos. 2019-184144, 2019-184145 and 2020-098944 are herein incorporated entirely by reference. All publications, patent applications, and technical standards mentioned in this specification are herein incorporated by reference to the same extent as if each individual publication, patent application, or technical standard was specifically and individually indicated to be incorporated by reference.

## Claims

1. A heating element accommodation case, comprising a casing to accommodate a heating element, the casing having a flow channel configured for a liquid to flow through, a portion of the flow channel being formed of a resin.

2. The heating element accommodation case according to claim 1, wherein the casing has a metal portion that includes a metal.

3. The heating element accommodation case according to claim 2, wherein the metal portion has, at at least a part of a surface of the metal portion, a concave-convex structure that is formed by a roughening process.

4. The heating element accommodation case according to claim 2 or claim 3, wherein the casing further has a resin portion that includes a resin, and the metal portion has a concave-convex structure at a portion to be joined to the resin portion.

5. The heating element accommodation case according to any one of claim 2 to claim 4, wherein at least a part of the metal portion is disposed at a position configured to contact the heating element.

6. The heating element accommodation case according to any one of claim 1 to claim 5, wherein at least a part of a portion surrounding a space through which a liquid flows in the flow channel is formed of a resin.

7. The heating element accommodation case according to claim 6, wherein at least a part of a portion surrounding a space through which a liquid flows in the flow channel is formed of a metal.

8. The heating element accommodation case according to any one of claim 1 to claim 7, wherein the flow channel is disposed at at least one of a base portion, an upper portion or a side portion of the heating element.

9. The heating element accommodation case according to claim 8, wherein the flow channel is disposed at at least an upper portion of the heating element.

10. The heating element accommodation case according to claim 8, wherein the flow channel comprises a first flow channel disposed at a base portion of the heating element and a second flow channel disposed at an upper portion of the heating element, and one of the first flow channel or the second flow channel adjusts a temperature of a terminal of the heating element and the other of the first flow channel or the second flow channel adjusts a temperature of a main body of the heating element.

11. The heating element accommodation case according to claim 8, wherein the flow channel comprises a first flow channel disposed at a base portion of the heating element and a second flow channel disposed at an upper portion of the heating element, and one of the first flow channel or the second flow channel cools the heating element and the other of the first flow channel or the second flow channel warms the heating element.

12. The heating element accommodation case according to any one of claim 1 to claim 11, wherein at least one flow channel is disposed near a high-heating portion of the heating element.

13. A heating element accommodation case, comprising a casing to accommodate a heating element and an airflow channel configured for air to flow through.

14. The heating element accommodation case according to claim 13, wherein the airflow channel is isolated from a space in which the heating element is accommodated.

15. The heating element accommodation case according to claim 13 or claim 14, which is installed in a mobile object.

16. The heating element accommodation case according to claim 13 or claim 14, wherein the airflow channel is configured for air to flow along a direction in which the mobile object moves.

17. The heating element accommodation case according to claim 13 or claim 14, wherein air is caused to flow through the airflow channel by a blower.

18. The heating element accommodation case according to any one of claim 13 to claim 17, wherein at least a part of the airflow channel is formed of a metal.

19. The heating element accommodation case according to claim 18, wherein at least a portion of the airflow channel that contacts the casing is formed of a metal.

20. The heating element accommodation case according to claim 19, wherein the casing has a vent that communicates an inside of the casing with an outside of the casing.

21. A structure, comprising the heating element accommodation case according to any one of claim 1 to claim 20, and a heating element that is accommodated in the heating element accommodation case.

22. The structure according to claim 21, wherein the heating element is at least one selected from the group consisting of a secondary battery module, an electronic component device, and a power conversion device.
